# EUROPÄISCHE PATENTSCHRIFT

(11) **EP 3 479 655 B1**
(45) Veröffentlichungstag und Bekanntmachung des Hinweises auf die Patenterteilung: **02.10.2019**
(21) Anmeldenummer: 17808770.6
(22) Anmeldetag: 16.11.2017
(51) Int. Cl.: H05B 33/08

(54) **MESSANORDNUNG ZUR ERFASSUNG VON ALTERUNGSPROZESSEN EINZELNER LEUCHTDIODEN**
MEASURING ARRANGEMENT FOR DETECTING AGING PROCESSES OF INDIVIDUAL LIGHT-EMITTING DIODES
DISPOSITIF DE MESURE CONÇU POUR DÉTECTER DES PROCESSUS DE VIEILLISSEMENT DE DIODES ÉLECTROLUMINESCENTES INDIVIDUELLES

(30) Priorität: 08.12.2016 DE 102016014652
(43) Veröffentlichungstag der Anmeldung: 08.05.2019
(73) Patentinhaber: INOVA Semiconductors GmbH, 81671 München (DE)
(72) Erfinder: NEUMANN, Roland, 81671 München (DE)
(74) Vertreter: Reich, Jochen
(86) Internationale Anmeldenummer: PCT/EP2017/001348
(87) Internationale Veröffentlichungsnummer: WO 2018/103879

(56) Entgegenhaltungen:
- DE-A1- 10 239 449
- DE-A1-102008 034 524
- DE-A1-102009 053 911
- US-A1- 2010 327 764
- US-A1- 2011 057 571
- US-A1- 2016 003 670
- US-A1- 2016 343 349

## Beschreibung

Die vorliegende Erfindung ist gerichtet auf eine Messanordnung zur Erfassung von Alterungsprozessen einzelner Leuchtdioden, welche es ermöglicht, einen Helligkeitsverlust von Leuchtdioden zu erkennen und anschließend zu kompensieren. Hierbei wird eine relative Messung einer Helligkeitsintensität durchgeführt. Die vorliegende Erfindung ist ferner gerichtet auf ein entsprechend eingerichtetes Verfahren zum Erfassen von Alterungsprozessen einzelner Leuchtdioden sowie auf ein Computerprogrammprodukt mit Steuerbefehlen, welche das Verfahren implementieren.

US 2016/0003670 A1 zeigt eine Messanordnung zur Erfassung von Alterungsprozessen einer Photodiode.

US 2010/0327764 A1 zeigt eine intelligente Beleuchtungssteuerung in einer LED Anordnung zum Ausführen einer Reihe von Funktionen.

Gemäß bekannter Verfahren werden absolute Helligkeitswerte von Leuchtdioden bereits zu deren Herstellungszeit gemessen und abgespeichert. Aus einer Mehrzahl solcher Testreihen erwartet man sich dann Rückschlüsse, ausgehend von den absoluten Werten einer Änderung eines Leuchtverhaltens, auf zu erwartende Alterungsprozesse einer Leuchtdiode ziehen zu können. Somit werden entsprechende Parameter beispielsweise in einer Tabelle hinterlegt und oftmals unveränderlich an den Endkunden ausgeliefert.

So ist es bereits bekannt, eine Leuchtdiode bzw. eine Mehrzahl von Leuchtdioden derart zu verifizieren, dass ein Farbsensor vorgehalten wird, der das Leuchtverhalten einer Leuchtdiode misst. Hierbei sind Sensoren bekannt, die auf der sogenannten CCD bzw. CMOS Technologie basieren. Diese herkömmlich verwendeten Komponenten sind relativ groß und stehen daher einer kompakten Bauart entgegen. Zudem messen sie in aufwendiger Weise in bestimmten Wellenbereichen um hierbei ein farbiges Leuchtverhalten der zu testenden Leuchtdioden zu analysieren. Der Stand der Technik sieht deshalb relativ aufwendige Farbsensoren vor, da oftmals absolute Werte genau gemessen werden müssen und zudem bestimmte Farbspektren, beispielsweise nach einem rot-grün-blau Schema RGB, analysiert werden müssen. Dies stellt jedoch in der Praxis einen erheblichen technischen Aufwand dar.

Generell sind unterschiedliche Bauarten und Anordnungen von Leuchtdioden bekannt, die jedoch einem Alterungsprozess unterliegen. Dies kann beispielsweise daher rühren, dass bei dem Betreiben der Leuchtdioden eine Hitzeentwicklung auftritt, die wiederum zu einem entsprechenden Alterungsprozess in der Leuchtdiode führt bzw. diesen verstärkt. Dieser Alterungsprozess macht sich dadurch bemerkbar, dass die Leuchtdiode insgesamt an Leuchtkraft verliert. Wird also eine Leuchtdiode mit einer ersten Stromstärke angesprochen und über einen längeren Alterungsprozess hinweg mit der gleichen Stromstärke erneut angesprochen, so ergibt sich bei dem ersten Testdurchlauf ein hellerer Leuchtwert als bei dem zweiten Testdurchlauf.

Vorliegend ist dies besonders nachteilig, da sich die vorliegende Erfindung insbesondere auf den Automobilbereich bezieht, wo erhebliche Sicherheitsanforderungen gelten. Diese Sicherheitsanforderungen sind unter anderem in diversen DIN Normen spezifiziert und sind herstellerseitig einzuhalten.

Somit ist es gegenüber dem Stand der Technik besonders nachteilig, dass ein Alterungsprozess der Leuchtdioden auftritt, der nur mit erheblichem technischem Aufwand kompensiert werden kann. Insbesondere ist es hierbei nachteilig, dass Farbsensoren Einsatz finden, die in ihrer Bauart besonders ungeeignet sind und zudem einen hohen technischen Mehraufwand bedeuten. So ist bereits das Herstellen eines Farbsensors an sich technisch aufwendig. Somit hat der Fachmann gemäß bekannter Verfahren die Wahl, ob er den Alterungsprozess von Leuchtdioden einfach hinnimmt oder diesen Alterungsprozess in technisch aufwendiger Art und Weise kompensiert.

Hierbei ist es somit wünschenswert, ein Verfahren und eine entsprechende Systemanordnung bereitzustellen, die es ermöglicht, dass der Endkunde eine Leuchtdiode bzw. eine Mehrheit von Leuchtdioden erhält, die stets auch über Jahre hinweg ein gleiches Leuchtverhalten aufweisen. Hierbei ist es herstellerseitig gefordert, dass das Erfassen der Änderungen im Leuchtverhalten in technisch einfacher Weise und insbesondere besonders zuverlässig erfolgen kann.

Es ist somit eine Aufgabe der vorliegenden Erfindung eine Messanordnung zur Erfassung von Alterungsprozessen einzelner Leuchtdioden vorzuschlagen. Ferner ist es eine Aufgabe der vorliegenden Erfindung ein entsprechendes Verfahren zum Erfassen von Alterungsprozessen einzelner Leuchtdioden vorzuschlagen sowie ein Computerprogrammprodukt mit Steuerbefehl, welche das vorgeschlagene Verfahren implementieren.

Die Aufgabe wird gelöst durch eine Messanordnung zur Erfassung von Alterungsprozessen mit den Merkmalen des Patentanspruchs 1. Weitere vorteilhafte Ausgestaltungen sind in den Unteransprüchen angegeben.

Demgemäß wird eine Messanordnung zur Erfassung von Alterungsprozessen einzelner Leuchtdioden vorgeschlagen, aufweisend eine Mehrzahl von Leuchtdioden, ein Steuerwerk, eingerichtet zur individuellen Helligkeitsintensitätsregelung jeder der Leuchtdioden, wobei mindestens eine Fotodiode, eingerichtet zur Helligkeitsmessung mindestens einer Leuchtdiode vorgesehen ist, wobei das Steuerwerk eingerichtet ist in Abhängigkeit einer ersten Messung und einer zweiten zeitversetzten Messung eine relative Helligkeitsintensitätsänderung jeweils einer Leuchtdiode zu erfassen.

Die vorliegende Erfindung schafft den Vorteil, dass Alterungsprozesse, welche sich in einer Helligkeitsintensitätsänderung niederschlagen, sowohl erfasst als auch kompensiert werden können. Hierzu sind einzelne Leuchtdioden vorgesehen, welche typischerweise als RGB-Leuchtdioden vorliegen. Hierauf ist die vorliegende Erfindung jedoch nicht beschränkt sondern bezieht sich vielmehr auf jede beliebige Anzahl von Leuchtdioden, welche überwacht werden sollen. Somit kann es sich bei der Anzahl an Leuchtdioden, die in der Mehrzahl von Leuchtdioden umfasst ist, vorzugsweise um drei oder vier Leuchtdioden, handeln. Ferner ist es aber auch möglich, dass diverse Leuchtdioden in Serie geschaltet werden und somit die gesamte Serie an Leuchtdioden zu überwachen ist. Somit ist es ein Aspekt der vorliegenden Erfindung, dass eine Mehrzahl von Leuchtdioden drei oder vier Leuchtdioden umfasst und durch ein In-Serie-Schalten ein Vielfaches dieser Anzahl vorhanden sein kann.

Ferner ist ein Steuerwerk vorgesehen, welches die einzelnen Leuchtdioden aus der Mehrzahl von Leuchtdioden anspricht. Typischerweise erfolgt dies dadurch, dass ein gewisser Stromwert bzw. eine Spannung an jede einzelne Leuchtdiode angelegt wird und somit implizit auch eine gewisse Helligkeitsintensität eingestellt wird. Wie eingangs bereits beschrieben wurde, ist es bei Leuchtdioden besonders nachteilig, dass eine angelegte Spannung nicht zu jedem Zeitpunkt stets die gleiche Helligkeit hervorruft. Somit ist das Steuerwerk generell in der Lage, die einzelnen Leuchtdioden derart anzusprechen, dass diese auch ihre Helligkeit erhöhen. Tritt also ein Alterungsprozess einer Leuchtdiode ein, so muss im Laufe dieser Zeit die angelegte Spannung derart erhöht werden, dass stets die gleiche Helligkeit hervorgerufen wird.

Somit ist also das Steuerwerk eingerichtet die individuelle Helligkeitsintensitätsregelung einer jeden Leuchtdiode vorzunehmen. Eine individuelle Helligkeitsintensitätsregelung stellt darauf ab, dass die einzelnen Leuchtdioden tatsächlich auch einzeln angesprochen werden können. Somit kann eben auch die Helligkeit einer jeden Leuchtdiode einzeln eingestellt werden. Darüber hinaus ist es möglich, mittels des Steuerwerks ein Mischverhältnis der einzelnen Leuchtdioden derart einzustellen, dass ein bestimmter Farbwert erreicht wird. Somit kann beispielsweise eine rot leuchtende Leuchtdiode, eine grün leuchtende Leuchtdiode und eine blau leuchtende Leuchtdiode in ihrer Intensität derart eingestellt werden, dass sich ein bestimmter Farbwert einstellt. Verlieren hierbei jedoch einzelne Leuchtdioden an Leuchtkraft, so kommt es zu einer Störung eben dieses Mischverhältnisses.

Erfindungsgemäß ist es besonders vorteilhaft, dass eine Fotodiode Einsatz findet. Dies stellt gegenüber dem Stand der Technik insbesondere den Vorteil bereit, dass eine Fotodiode in besonders einfacher technischer Art und Weise bereitgestellt werden kann und das Auslesen technisch wenig aufwendig ist. Während also im Stand der Technik Farbsensoren verwendet werden, so wurde erfindungsgemäß besonders überraschend festgestellt, dass eine gewisse ansonsten nachteilige Fehlertoleranz der Fotodiode vernachlässigbar ist. Dies ist deshalb der Fall, da es nicht auf die absoluten Werte ankommt, welche gemäß herkömmlicher Verfahren gemessen werden, sondern vielmehr werden zeitversetzt zwei Messungen genommen und anhand der Fotodiode soll lediglich der relative Unterschied zwischen beiden Messergebnissen festgestellt werden. Somit ist es erfindungsgemäß besonders vorteilhaft, dass hier besonders einfache Fotodioden Anwendung finden können. Hiervon wird der Fachmann generell abgehalten, da Fotodioden oftmals ungenauer messen als Farbsensoren und eben auch nicht zwingendermaßen ein Farbspektrum messen. Somit lässt sich also ein relativ kostengünstiger Messfühler bereitstellen, dessen Messtoleranz sich nicht nachteilig auf das Ergebnis der Helligkeitsintensitätsmessung auswirkt. Daher kann also eine Messeinrichtung in Form einer Fotodiode Verwendung finden, die sowohl zuverlässig als auch mit wenig technischem Aufwand betrieben werden kann.

Die Fotodiode bzw. die mindestens eine Fotodiode wird zur Helligkeitsintensitätsmessung mindestens einer Leuchtdiode der Art bezüglich der zu messenden Leuchtdiode angeordnet, dass eine optische Sichtverbindung möglich ist. Alternativ ist es auch möglich, dass zwischen der Fotodiode und der Leuchtdiode keine optische Verbindung besteht, sondern dass vielmehr die Fotodiode derart ausgerichtet wird, dass sie lediglich reflektiertes passives Licht misst. Der Fachmann kennt hierbei weitere Anordnungen, die es einer Fotodiode ermöglichen eine Lichtquelle auszumessen. Hierbei ist es besonders vorteilhaft, dass sich die Fotodiode in räumlicher Nähe zu der Leuchtdiode befindet. Auch hierbei wird in besonders vorteilhafter Weise eine Toleranz gewährt, da das vorliegende Verfahren bzw. die vorgeschlagene Messanordnung lediglich auf relative Werte abstellt. Somit ist die räumliche Distanz zwischen Fotodiode und Leuchtdiode nicht spezifisch zu definieren, sondern vielmehr ist es vorteilhaft, falls die Fotodiode zur Leuchtdiode stets während den Messungen in gleicher Position bzw. Abstand angeordnet ist.

Ferner ist es möglich mittels einer Fotodiode eine Helligkeitsintensitätsmessung genau einer Leuchtdiode durchzuführen, oder aber auch mittels einer Fotodiode mehrere Leuchtdioden auszumessen. So kann die Fotodiode derart bezüglich einer oder mehrerer Leuchtdioden angeordnet werden, dass ein entsprechendes Leuchtverhalten bzw. eine Helligkeitsintensität ausgemessen werden kann. Insbesondere ist es möglich eine Fotodiode derart auszugestalten, dass sie breitbandig bzw. mehrbandig messen kann. Somit ist es also besonders vorteilhaft, dass mit einer einzelnen Fotodiode eine beliebige Teilmenge aus rotem, grünem und blauem Licht gemessen werden kann. Dies kann derart erfolgen, dass die Fotodiode derart ausgestaltet wird, dass sie die einzelnen Spektren unterschiedlicher Leuchtdioden messen kann. Somit reicht bereits eine einzige Fotodiode aus um eine beliebige Anzahl von Leuchtdioden, vorzugsweise drei oder vier, auszumessen, die jeweils eine charakteristische Wellenlänge aussenden. Ferner ist es auch möglich bezüglich jeder einzelnen Leuchtdiode eine einzelne spezielle Fotodiode vorzusehen. Hierbei kann die Fotodiode in räumlicher Nähe zu derjenigen Leuchtdiode angeordnet werden, die eben diese Fotodiode ausmessen soll.

Ferner ist es auch möglich Fotodioden derart redundant anzuordnen, dass für eine Leuchtdiode auch mehrere Fotodioden vorgesehen sind. Hiermit lässt sich also einem Ausfall einer Fotodiode vorbeugen. Ferner ist es möglich die Messwerte einzelner Fotodioden zu mitteln, derart, dass ein besonders zuverlässiger Mittelwert entsteht.

Aufgrund des Alterungsprozesses erfolgen eine erste Messung und eine zeitversetzte zweite Messung der Helligkeitsintensität mindestens einer Leuchtdiode. Hierbei kann es sich um ein stets wiederkehrendes Messintervall handeln, es kann jedoch auch erst nach einer vorbestimmten Zeitdauer die zweite Messung abhängig von dem Startzeitpunkt der ersten Messung durchgeführt werden. Hierbei kann ein Messzeitpunkt statisch hinterlegt werden, oder es wird ein relatives Messintervall bestimmt, nachdem in Abhängigkeit der ersten Messung die zweite Messung durchgeführt wird. Ferner ist es möglich das Messintervall, also den zeitlichen Versatz, in Abhängigkeit einer Leuchtdiodennutzung einzustellen. So ist es vorteilhaft Leuchtdioden, welche besonders häufig benutzt werden bzw. besonders lange benutzt werden häufiger auszumessen und hierbei zu mindestens einem vergangenen Messpunkt eine Helligkeitsintensitätsänderung zu bestimmen. So ist die vorliegende Erfindung keinesfalls auf eine erste Messung und eine zweite zeitversetzte Messung beschränkt, sondern vielmehr kann eine Vielzahl von Messungen durchgeführt werden, wobei die vorhergehende zweite zeitversetzte Messung wiederum zur ersten Messung wird und somit einen relativen Startzeitpunkt bezüglich einer weiteren zweiten Messung darstellt. Somit ist eine beliebige Anzahl von zeitlich versetzter Messungen möglich, bezüglich derer die relative Helligkeitsintensitätsänderung erfindungsgemäß bestimmbar ist. Hierbei ist es möglich jeden beliebigen zeitlichen Versatz einzustellen um dem zu Grunde liegenden Anwendungsszenario der Leuchtdioden gerecht zu werden.

Somit wird bei der ersten Messung eine Helligkeitsintensität mindestens einer Leuchtdiode gemessen und bei der zweiten zeitversetzte Messung eine zweite Helligkeitsintensität der vorab gemessenen Leuchtdiode bzw. der Leuchtdioden. Daraus lässt sich die relative Helligkeitsintensitätsänderung bestimmen. Dies kann beispielsweise ein Subtrahieren beider Helligkeitsintensitäten umfassen. Hierbei sei insbesondere darauf hingewiesen, dass gemäß der vorliegenden Erfindung nicht auf die absoluten Werte an sich abgestellt wird, sondern vielmehr finden nur die relativen Helligkeitsintensitätsänderungen Verwendung, derart, dass der vorhandene Unterschied gemäß den weiteren optionalen Verfahrensschritten oder mit weiteren optionalen strukturellen Merkmalen ausgeglichen wird.

Somit stellt sich insbesondere erfinderisch der Vorteil ein, dass eine Ungenauigkeit bei der Messung der absoluten Helligkeitsintensitäten in Kauf genommen werden kann, ohne dass hierbei ein verfälschtes Ergebnis zu erwarten wäre. Selbst wenn eine Fotodiode fehlerbehaftet wäre, so würde sich bei der ersten Messung der gleiche Fehler einstellen will bei der zweiten Messung. Somit kann dennoch in richtiger Weise die Helligkeitsintensitätsänderung bestimmt werden und dementsprechend auch die Helligkeitsintensitätsänderung ausgeglichen werden. Ergibt beispielsweise die relative Helligkeitsintensitätsänderung, dass die Leuchtkraft zu einem bestimmten Prozentsatz nachgelassen hat, so kann das Steuerwerk die anliegende Spannung eben auch um diesen Prozentsatz derart erhöhen, dass sich wieder die gleiche Helligkeitsintensität einstellt. Der Fachmann erkennt hierbei, in wieweit ein linearer Zusammenhang zwischen der angelegten Spannung und der Helligkeitsintensitätsänderung besteht. Somit erkennt der Fachmann auch, in wie weit er eine Leuchtdiode nunmehr anzusteuern hat, um eine Helligkeitsintensitätsänderung zu kompensieren. Somit wird also eine Messanordnung mitsamt einem entsprechenden Verfahren zur Erfassung und Kompensation von Alterungsprozessen, also deren Korrektur, vorgeschlagen.

Gemäß einem Aspekt der vorliegenden Erfindung ist das Steuerwerk eingerichtet, die erfasste Helligkeitsintensitätsänderung im Wesentlichen zu kompensieren. Dies hat den Vorteil, dass die Helligkeitsintensitätsänderung zumindest derart kompensiert werden kann, dass der menschliche Benutzer kein verändertes Leuchtverhalten der Leuchtdioden feststellen kann. So kann direkt nach der zweiten Messung die Helligkeitsintensitätsänderung derart kompensiert werden, dass wieder die ursprüngliche Leuchtkraft der einzelnen Leuchtdioden eingestellt wird. Hierbei ist es besonders bevorzugt, dass die Helligkeitsintensitätsänderung vollständig kompensiert wird, was jedoch technisch wiederum sehr aufwendig sein kann. Somit ist es erfindungsgemäß besonders vorteilhaft, dass die Helligkeitsintensitätsänderung im Wesentlichen kompensiert wird. Jedoch bemerkt der Endkunde, beispielsweise ein Autofahrer, auch nach langjährigen Gebrauch der Leuchtdioden keinerlei Unterschied in der Leuchtkraft bzw. im Mischverhältnis der einzelnen Leuchtdioden.

Gemäß am weiteren Aspekt der vorliegenden Erfindung wird die mindestens eine Leuchtdiode derart angesteuert, dass sich die Helligkeitsintensität der ersten Messung einstellt. Dies hat den Vorteil, dass die erste Messung als Bezugspunkt abgespeichert werden kann und dann nach der zweiten zeitversetzten Messung wieder die ursprüngliche Leuchtkraft bzw. Helligkeitsintensität eingestellt werden kann. Somit wird sichergestellt, dass über den gesamten Lebenszyklus der Leuchtdiode stets der Helligkeitsintensitätswert eingestellt werden kann, wie er zur Herstellungszeit der Leuchtdiode erzeugbar war. Hierbei sei darauf hingewiesen, dass eine Helligkeitsintensitätsmessung auch in Abhängigkeit einer angelegten Spannung bzw. eines beaufschlagten Stroms durchgeführt werden kann. So muss die Leuchtdiode bei der ersten Messung und der zweiten Messung stets mit den gleichen Parametern betrieben werden, um tatsächlich auch die Helligkeitsintensitätsänderung aufgrund des Alterungsprozesses festzustellen. So ist es möglich die Leuchtdiode, beziehungsweise die Leuchtdioden mittels Pulsweitenmodulation zu dimmen. Wird also eine Leuchtdiode bei der ersten Messung zu 100% betrieben, so muss sie auch bei der zweiten Messung mit 100% betrieben werden. Wird hingegen die Leuchtdiode bei dem ersten Messvorgang zu 50% gedimmt, so muss diese auch bei der zweiten Messung entsprechend gedimmt werden. Die Möglichkeit der Pulsweitenmodulation zum Dimmen von Leuchtdioden ist dem Fachmann hierbei bereits bekannt.

Gemäß einem weiteren Aspekt der vorliegenden Erfindung sind die Mehrzahl der Leuchtdioden und die mindestens eine Fotodiode in einem Gehäuse angeordnet. Dies hat den Vorteil, dass die Fotodiode derart abgeschirmt werden können, dass lediglich eine Helligkeitsintensität der zu messenden Leuchtdioden detektierbar ist. Somit wird erfindungsgemäß ausgeschlossen, dass weitere Lichtquellen auf die Fotodioden einwirken und hierbei die Messergebnisse verfälschen könnten. Dies ist insbesondere deshalb vorteilhaft, da bei Leuchtdioden stets ein Gehäuse vorzusehen ist und somit die Fotodiode bzw. die Fotodioden in dieses bereits bestehende Gehäuse eingebracht werden können. Somit kann das Anordnen der Leuchtdioden und der Fotodioden in dem Gehäuse in einem Arbeitsschritt ausgeführt werden.

Gemäß einem weiteren Aspekt der vorliegenden Erfindung sind die Mehrzahl von Leuchtdioden und die mindestens eine Fotodiode einstückig ausgeformt. Dies hat den Vorteil, dass die Leuchtdioden und die Fotodioden derart zueinander angeordnet werden, dass diese nicht zerstörungsfrei trennbar sind. Dies wird vorzugsweise derart bewerkstelligt, dass die Leuchtdioden und die Fotodioden in einem gemeinsamen Gehäuse angeordnet sind, derart, dass das Gehäuse aufweisend die Leuchtdioden und die Fotodioden eine Einheit bildet. Hierbei ist nicht zwingendermaßen gefordert, dass die Leuchtdioden und die Fotodiode derart zueinander angeordnet sind, dass diese in Kontakt stehen. Vielmehr wird die vorgeschlagene Messanordnung in einem Gehäuse derart verpackt, dass diese als einstückige Einheit ausgeliefert werden kann.

Gemäß einem weiteren Aspekt der vorliegenden Erfindung liegt das Steuerwerk als ein Mikrocontroller, eine Finite State Machine, ein analoger Regelkreis und/ oder eine elektronische Komponente vor. Dies hat den Vorteil, dass das Steuerwerk auf eine Mehrzahl von Bauarten hergestellt werden kann und insbesondere, dass bestehende Steuerwerke wieder verwendet werden können. Hierbei erkennt der Fachmann, dass das Steuerwerk auch weitere Komponenten aufweisen kann, beispielsweise einen Leuchtdioden-Treiber.

Gemäß einem weiteren Aspekt der vorliegenden Erfindung liegt die Mehrzahl von Leuchtdioden als eine rot-Leuchtdiode, eine grün-Leuchtdiode und eine blau-Leuchtdiode vor. Dies hat den Vorteil, dass bestehende Ansteuerungsverfahren und insbesondere bestehende Leuchtdioden-Anordnungen erfindungsgemäß wieder verwendet werden können. So lässt sich anhand der vorgeschlagenen Leuchtdioden mittels eines Mischverhältnisses jeder beliebige Farbwert, also Wellenlänge, einstellen. Somit können also auch bestehende Leuchtdioden erfinderisch derart nachgerüstet werden, dass hierzu lediglich Fotodioden vorgesehen werden müssen. Somit eignet sich die vorgeschlagenen Messanordnung bzw. das vorgeschlagene Verfahren auch zum Nachrüsten bestehender Leuchtdioden, derart dass eine Mehrzahl von Leuchtdioden sowie ein Steuerwerk bereitgestellt werden. In weiteren Verfahrensschritten werden dann die Fotodioden bzw. die Fotodiode bereitgestellt und das Steuerwerk entsprechend dem kennzeichnenden Teil des unabhängigen Patentanspruchs, der auf die Messanordnung gerichtet ist, angepasst.

Gemäß einem weiteren Aspekt der vorliegenden Erfindung liegt die Mehrzahl von Leuchtdioden als eine rot-Leuchtdiode, eine grün-Leuchtdiode, eine blau-Leuchtdiode und eine weiß-Leuchtdiode vor. Dies hat den Vorteil, dass auch bestehende Leuchtdioden wiederverwendet werden können und insbesondere, dass die vorgeschlagene Messanordnung bzw. das vorgeschlagene Verfahren auf jegliche Bauart von Leuchtdioden Anwendung finden kann.

Gemäß einem weiteren Aspekt der vorliegenden Erfindung ist die Fotodiode breitbandig ausgestaltet. Dies hat den Vorteil, dass mittels der Fotodiode mehrere Farbspektren derart gemessen werden können, dass für die vorgeschlagenen Leuchtdioden unterschiedlicher Wellenlänge jeweils eine Helligkeitsintensitätsmessung durchgeführt werden kann. Somit stellt sich also der Vorteil ein, dass beispielsweise lediglich eine einzelne Fotodiode bereitgestellt werden muss, welche dann gesondert die Farbspektren, beispielsweise rot, grün und blau, messen kann. Hierbei wird jedoch davon abgesehen einen sogenannten CCD Sensor bzw. einen CMOS Sensor zu verwenden. Vielmehr ist eine einzelne Fotodiode vorzusehen, welche gesondert die einzelnen Leuchtdioden ausmessen kann.

Gemäß einem weiteren Aspekt der vorliegenden Erfindung ist für die grüne Leuchtdiode und die blaue Leuchtdiode jeweils eine Fotodiode vorgesehen. Dies hat den Vorteil, dass gerade diejenigen Leuchtdioden mittels einer eigenen Fotodiode überwacht werden, die besonders Temperatur anfällig sind. Hierbei wurde überraschenderweise festgestellt, dass eine rote Leuchtdiode einem geringeren Alterungsprozess unterliegt, als die weiteren Leuchtdioden, da eine rote Leuchtdiode weniger Wärme produziert als eine grüne oder eine blaue Leuchtdiode. Somit ist es erfindungsgemäß besonders vorteilhaft, dass auch falls drei oder vier Leuchtdioden verbaut werden, lediglich zwei Fotodioden oder drei Fotodioden vorzusehen sind. So kann stets die rote Leuchtdiode nicht überwacht bleiben, da diese eben weniger Hitzeentwicklung aufweist und somit die entsprechende Fotodiode angespart werden kann. Somit ergibt sich wiederum ein besonders robustes Messsystem das zudem mit geringem technischem Aufwand hergestellt werden kann. Ferner kann die vorgeschlagene Messanordnung effizient betrieben werden, was insbesondere dann vorteilhaft ist, falls diverse Messanordnungen in Serie geschaltet werden.

Gemäß am weiteren Aspekt der vorliegenden Erfindung ist für jede Leuchtdiode eine gesonderte Fotodiode vorgesehen, die deren Helligkeitsintensität misst. Dies hat den Vorteil, dass für jede Leuchtdiode besonders zuverlässig die entsprechende Helligkeitsintensitätsänderung gemessen werden kann. Weist die Mehrzahl von Leuchtdioden beispielsweise drei Leuchtdioden auf, so sind auch drei Fotodioden vorgesehen, wobei bei vier Leuchtdioden eben auch vier Fotodioden vorgesehen sind. Hierdurch lässt sich in besonders exakter Weise eine Änderung in der Helligkeitsintensität einzelner Leuchten feststellen.

Gemäß einem weiteren Aspekt der vorliegenden Erfindung wird die Helligkeitsintensitätsänderung in Abhängigkeit einer Benutzereingabe erfasst. Dies hat den Vorteil, dass ein Benutzer, der ein bestimmtes Farbspektrum bevorzugt, dieses auch beispielsweise als Innenbeleuchtung seines Fahrzeugs einstellen kann. Da dieses Farbspektrum und somit auch ein Betreiben der entsprechenden Leuchtdiode besonders oft vorherrscht, liegt hier ein intensiverer bzw. schnellerer Alterungsprozess verglichen mit den weiteren Leuchtdioden vor. Wählt ein Benutzer beispielsweise generell eine rote Innenbeleuchtung seines Fahrzeugs, so ist gerade die rote Leuchtdiode einem erhöhten Verschleiß bzw. einem erhöhten Alterungsprozess ausgesetzt. Somit ist es möglich das erste Messen und das zweite Messen besonders häufig für die rote Leuchtdiode auszuführen. Somit wird die Helligkeitsintensitätsänderung häufiger erfasst und kann entsprechend kompensiert werden.

Herrscht jedoch eine Benutzereingabe vor, die vorsieht, dass eine bestimmte Leuchtdiode nie angesprochen wird, so muss diese Leuchtdiode auch nicht bezüglich ihrer Helligkeitsintensitätsänderung erfasst und kompensiert werden. Hierbei erscheint es jedoch vorteilhaft, die Helligkeitsintensitätsänderung zumindest gelegentlich zu bestimmen und zu kompensieren, da auch ein natürlicher Alterungsprozess vorliegen kann. Somit werden die Messungen, das Erfassen und das Kompensieren auf unterschiedlichen Leuchtdioden unterschiedlich oft ausgeführt. Hierdurch wird wiederum technischer Aufwand eingespart.

Die Aufgabe wird auch gelöst durch ein Verfahren zum Erfassen von Alterungsprozessen einzelner Leuchtdioden, aufweisend die Schritte des Bereitstellens einer Mehrzahl von Leuchtdioden, sowie ein Bereitstellen eines Steuerwerks, eingerichtet zur individuellen Helligkeitsintensitätsregelung jeder der Leuchtdioden, wobei mindestens eine Fotodiode eingerichtet zur Helligkeitsintensitätsmessung mindestens einer Leuchtdiode vorgesehen wird, wobei das Steuerwerk in Abhängigkeit eines ersten Messens und eines zweiten zeitversetzten Messens eine relative Helligkeitsintensitätsänderung jeweils einer Leuchtdiode erfasst.

Gemäß einem weiteren Aspekt der vorliegenden Erfindung wird die erfasste Helligkeitsintensitätsänderung im Wesentlichen kompensiert. Dies hat den Vorteil, dass die Helligkeitsintensitätsänderung nicht lediglich erfasst wird, sondern eben auch kompensiert wird. Im Wesentlichen stellt darauf ab, dass die Helligkeitsintensitätsänderung ganz oder mindestens derart kompensiert wird, dass der menschliche Benutzer keine Farbabweichung wahrnimmt.

Die Aufgabe wird auch gelöst durch ein Computerprogrammprodukt mit Steuerbefehlen, welche das vorgeschlagene Verfahren implementieren bzw. die vorgeschlagene Messanordnung betreiben. Somit kann das Verfahren als Software oder hardwaretechnisch bereitgestellt werden.

Hierbei ist es insbesondere vorteilhaft, dass die vorgeschlagene Messanordnung strukturelle Merkmale aufweist, welche ebenso als Verfahrensschritte implementiert werden können. Ferner ist es möglich, die vorgeschlagenen Verfahrensschritte auch als strukturelle Merkmale der Messanordnung nachzubilden. Das Computerprogrammprodukt ist hierbei geeignet die einzelnen Verfahrensschritte umzusetzen bzw. die Messanordnung zu betreiben oder zumindest einzelne Komponenten zu betreiben. Insgesamt lässt sich also die bereitgestellte Funktionalität durch die Messanordnung auch als Verfahrensschritte umsetzen.

Weitere vorteilhafte Ausgestaltungen werden anhand der beigefügten Figuren näher erläutert. Es zeigen:
- Figur 1:: ein Blockschaltbild einer Messanordnung zur Erfassung von Alterungsprozessen gemäß einem Aspekt der vorliegenden Erfindung; und
- Figur 2:: ein schematisches Ablaufdiagramm eines Verfahrens zum Erfassen von Alterungsprozessen gemäß einem weiteren Aspekt der vorliegenden Erfindung.

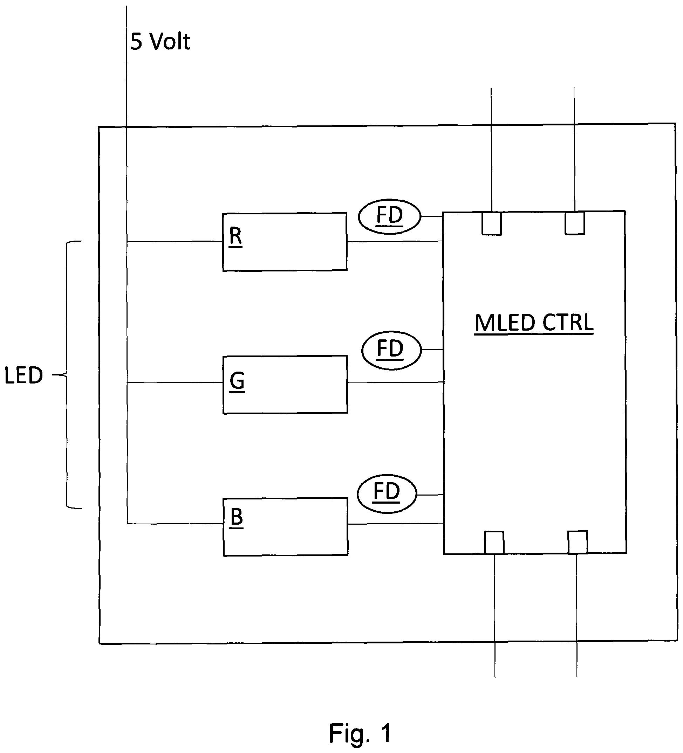

Figur 1 zeigt in einer Draufsicht die vorgeschlagene kompakte Leuchtdioden-Anordnung, wobei auf der linken Seite Leuchtdioden LED angeordnet sind. Hierbei handelt es sich vorliegend um eine rote R, eine grüne G, und eine blaue B Leuchtdiode LED. Auf der rechten Seite ist ein MLED Controller, also ein Steuerwerk CTRL angeordnet. Ferner ist in der Nähe einer jeden Leuchtdiode eine Fotodiode FD derart angeordnet, dass die Fotodiode die Helligkeitsintensität der entsprechenden Leuchtdiode messen kann. Die Fotodioden sind hierbei mit dem Steuerwerk kommunikativ gekoppelt. Auf dem Steuerwerk ist eine Logik implementiert, die das Steuerwerk veranlasst die vorgeschlagenen Messungen auszulösen und die entsprechenden Messwerte entgegenzunehmen. Aus der ersten Messung und der zweiten Messung kann somit das Steuerwerk die relative Helligkeitsintensitätsänderung bestimmen.

Wie in der vorliegenden Figur 1 ersichtlich ist, sind alle benötigten Bauteile innerhalb des Gehäuses verbaut. Somit können kann also das Steuerwerk und die Leuchtdioden in demselben Gehäuse platziert werden. Das Gehäuse ist derart ausgestaltet, dass es teilweise opak ausgestaltet ist wobei transparente oder semi-transparente Fensterbereiche vorgesehen sind. Mittels dieser Fensterbereiche ist es möglich die eingestellte Helligkeitsintensität der einzelnen Leuchtdioden von außerhalb des Gehäuses wahrzunehmen. Dies kann sich dadurch manifestieren kommt, dass die Leuchtdioden in einem bestimmten Mischverhältnis angesprochen werden, sodass sich ein vorbestimmter Farbwert einstellt. Somit manifestiert sich das Betreiben der Leuchtdioden mittels eines farbigen Lichts. Als Gehäuse eignet sich insbesondere ein Chipgehäuse, auch als Package bezeichnet.

Hierbei ist der Fensterbereich typischerweise nicht ganz transparent, so dass ein gewisser Prozentsatz von dem erzeugten Licht der Leuchtdioden wieder in das Gehäuse zurück reflektiert wird. Hierbei ist es erfindungsgemäß wiederum besonders vorteilhaft, dass die Fotodioden lediglich die relative Helligkeitsintensitätsänderung bestimmen und somit nicht nur eine Helligkeitsintensitätsmessung der einzelnen Leuchtdioden durchführen, sondern, dass alle Beteiligten Systemkomponenten, beispielsweise also auch der reflektierende Fensterbereich, berücksichtigt werden. Gemäß herkömmlicher Verfahren würde dies zu einer Verfälschung der Messergebnisse führen, da gemäß dem Stand der Technik typischerweise absolute Intensitätswerte Verwendung finden. Vorliegend wird also auch die Dimension, also die Abmessungen, des Gehäuses ausgeblendet, da wiederum lediglich ein relativer Wert der Helligkeitsintensitätsänderung Verwendung findet. Gemäß herkömmlichen Verfahren kann es bereits zu einer Verfälschung der absoluten Messwerte dadurch kommen, dass das Gehäuse einer ersten Mehrzahl von Leuchtdioden anders ausgestaltet ist als das Gehäuse einer zweiten Mehrzahl von Leuchtdioden. Da gemäß herkömmlicher Verfahren lediglich statische Werte Verwendung finden, reagieren diese nicht flexibel auf konkrete Ausgestaltungen weiterer Systemkomponenten, wie beispielsweise dem Fensterbereich und der Gehäuseabmessungen.

Erfindungsgemäß tritt hierbei keine Verfälschung auf, da stets unter gleichen Bedingungen die Helligkeitsintensitätsänderung gemessen wird. Somit wird also auch in zuverlässiger Art und Weise ein Kompensieren eben dieser Änderung durchgeführt. Somit eignet sich die vorgeschlagenen Messanordnung bzw. das vorgeschlagene Verfahren insbesondere in einem automobilen Anwendungsszenario, da die Leuchtdioden sicherheitsrelevant sein können und insbesondere bei einem autonomen Fahren maschinenbasiert ausgelesen werden. Somit sind Abweichungen in einer Helligkeitsintensität unbedingt zu erfassen und zu kompensieren. Somit stellt sich erfindungsgemäß der Vorteil ein, dass das vorgeschlagene Messverfahren und die Messanordnung besonders zuverlässig arbeiten und insbesondere sehr farbtreue Leuchtdioden bereitstellen bzw. betreiben.

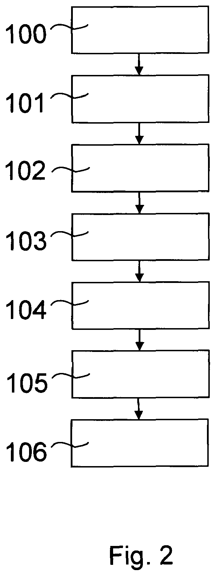

Figur 2 zeigt in einem schematischen Ablaufdiagramm ein Verfahren zum Erfassen von Alterungsprozessen einzelner Leuchtdioden, aufweisend die Schritte eines Bereitstellens 100 einer Mehrzahl von Leuchtdioden, ein Bereitstellen 101 eines Steuerwerks, eingerichtet zur individuellen Helligkeitsintensitätsregelung jeder der Leuchtdioden, wobei mindestens eine Fotodiode eingerichtet zur Helligkeitsintensitätsmessung mindestens einer Leuchtdiode vorgesehen 102 wird, wobei das Steuerwerk in Abhängigkeit eines ersten Messens 103 und eines zweiten zeitversetzten Messens 104 eine relative Helligkeitsintensitätsänderung jeweils einer Leuchtdiode erfasst 105. In einem weiteren, optionalen Verfahrensschritt 106 erfolgt ein Kompensieren der Helligkeitsintensitätsänderung ganz oder zumindest näherungsweise.

Vorliegend nicht gezeigt ist ein Computerprogrammprodukt mit Steuerbefehlen, welche das vorgeschlagene Verfahren implementieren bzw. die vorgeschlagene Messanordnung betreiben. Generell kann das Verfahren als Software oder hardwaretechnisch bereitgestellt werden.

## Patentansprüche

1. Messanordnung zur Erfassung von Alterungsprozessen einzelner Leuchtdioden (LED), aufweisend:
- eine Mehrzahl von Leuchtdioden (LED), umfassend eine Rot-Leuchtdiode (R), eine Grün-Leuchtdiode (G) und eine Blau-Leuchtdiode (B);
- ein Steuerwerk (CTRL), eingerichtet zur individuellen Helligkeitsintensitätsregelung jeder der Leuchtdioden (LED), **dadurch gekennzeichnet, dass**
- mindestens zwei Fotodioden (FD), jeweils eingerichtet zur Helligkeitsintensitätsmessung einer Leuchtdiode (LED) der Mehrzahl von Leuchtdioden (LED), welche nicht der Rot-Leuchtdiode (R) entspricht, vorgesehen ist, wodurch die Rot-Leuchtdiode (R) nicht überwachbar ist, wobei das Steuerwerk (CTRL) eingerichtet ist, in Abhängigkeit einer ersten Messung und einer der ersten Messung zeitversetzten zweiten Messung eine relative Helligkeitsintensitätsänderung jeweils einer Leuchtdiode der Mehrzahl von Leuchtdioden (LED) zu erfassen, wobei für die Grün-Leuchtdiode (G) und die Blau-Leuchtdiode (B) jeweils eine gesonderte Fotodiode vorgesehen ist.

2. Messanordnung nach Anspruch 1, **dadurch gekennzeichnet, dass** das Steuerwerk (CTRL) eingerichtet ist, die erfasste Helligkeitsintensitätsänderung im Wesentlichen zu kompensieren.

3. Messanordnung nach Anspruch 1 oder 2, **dadurch gekennzeichnet, dass** die mindestens eine Leuchtdiode (LED) derart angesteuert wird, dass sich die Helligkeitsintensität der ersten Messung einstellt.

4. Messanordnung nach einem der vorhergehenden Ansprüche, **dadurch gekennzeichnet, dass** die Mehrzahl der Leuchtdioden (LED) und die mindestens zwei Fotodioden (FD) in einem Gehäuse angeordnet ist.

5. Messanordnung nach einem der vorhergehenden Ansprüche, **dadurch gekennzeichnet, dass** die Mehrzahl der Leuchtdioden (LED) und die mindestens zwei Fotodioden (FD) einstückig ausgeformt ist.

6. Messanordnung nach einem der vorhergehenden Ansprüche, **dadurch gekennzeichnet, dass** das Steuerwerk (CTRL) als ein Mikrocontroller, eine Finite State Machine, ein analoger Regelkreis und/ oder eine elektronische Komponente vorliegt.

7. Messanordnung nach einem der vorhergehenden Ansprüche, **dadurch gekennzeichnet, dass** die Mehrzahl von Leuchtdioden (LED) als eine Rot-Leuchtdiode (R), eine Grün-Leuchtdiode (G), eine Blau-Leuchtdiode (B) und eine Weiß-Leuchtdiode vorliegt.

8. Messanordnung nach einem der vorhergehenden Ansprüche, **dadurch gekennzeichnet, dass** die Fotodiode (FD) breitbandig ausgestaltet ist.

9. Messanordnung nach einem der vorhergehenden Ansprüche, **dadurch gekennzeichnet, dass** die Helligkeitsintensitätsänderung in Abhängigkeit einer Benutzereingabe erfasst wird.

10. Verfahren zum Erfassen von Alterungsprozessen einzelner Leuchtdioden (LED), aufweisend die Schritte:
- Bereitstellen (100) einer Mehrzahl von Leuchtdioden (LED), umfassend eine Rot-Leuchtdiode (R), eine Grün-Leuchtdiode (G) und eine Blau-Leuchtdiode (B);
- Bereitstellen (101) eines Steuerwerks (CTRL), eingerichtet zur individuellen Helligkeitsintensitätsregelung jeder der Leuchtdioden (LED), **dadurch gekennzeichnet, dass**
- mindestens zwei Fotodioden (FD) jeweils eingerichtet zur Helligkeitsintensitätsmessung einer Leuchtdiode der Mehrzahl von Leuchtdioden (LED), welche nicht der Rot-Leuchtdiode (R) entspricht, vorgesehen (102) wird, wodurch die Rot-Leuchtdiode (R) nicht überwachbar ist, wobei das Steuerwerk (CTRL) in Abhängigkeit eines ersten Messens (103) und eines der ersten Messung zeitversetzten zweiten Messens (104) eine relative Helligkeitsintensitätsänderung jeweils einer Leuchtdiode der Mehrzahl von Leuchtdioden (LED) erfasst (105), wobei für die Grün-Leuchtdiode (G) und die Blau-Leuchtdiode (B) jeweils eine gesonderte Fotodiode vorgesehen ist.

11. Verfahren gemäß Patentanspruch 10, **dadurch gekennzeichnet, dass** die erfasste Helligkeitsintensitätsänderung im Wesentlichen kompensiert (106) wird.

12. Computerprogrammprodukt mit Steuerbefehlen, welche das Verfahren nach einem der Ansprüche 10 oder 11 implementieren.

## Claims

1. A measurement arrangement for detecting ageing processes in individual light-emitting diodes (LED), comprising:
- a plurality of light-emitting diodes (LED), comprising a red light-emitting diode (R), a green light-emitting diode (G) and a blue light-emitting diode (B);
- a control unit (CTRL) arranged to individually regulate the brightness intensity of each of the light-emitting diodes (LED), **characterised in that**
- at least two photodiodes (FD) respectively arranged to measure the brightness intensity of one light-emitting diode (LED) of the plurality of light-emitting diodes (LED) which does not correspond to the red light-emitting diode (R) are provided, causing the red light-emitting diode (R) not to be monitorable, the control unit (CTRL) being set up to detect a relative change in brightness intensity of each light-emitting diode (LED) of the plurality of light-emitting diodes (LED) as a function of a first measurement and a second measurement being time-offset to the first measurement, wherein respectively for the green light-emitting diode (G) and the blue light-emitting diode (B) a separate photodiode (FD) is provided.

2. The measurement arrangement according to claim 1, **characterised in that** the control unit (CTRL) is arranged to substantially compensate the detected change in brightness intensity.

3. The measurement arrangement according to either claim 1 or claim 2, **characterised in that** the at least one light-emitting diode (LED) is controlled in such a way that the brightness intensity of the first measurement is set.

4. The measurement arrangement according to any of the preceding claims, **characterised in that** the plurality of light-emitting diodes (LED) and the at least one photodiode (FD) are arranged in a housing.

5. The measurement arrangement according to any of the preceding claims, **characterised in that** the plurality of light-emitting diodes (LED) and the at least one photodiode (FD) are formed in a single piece.

6. The measurement arrangement according to any of the preceding claims, **characterised in that** the control unit (CTRL) is in the form of a microcontroller, a finite state machine, an analogue control circuit and/or an electronic component.

7. The measurement arrangement according to any of the preceding claims, **characterised in that** the plurality of light-emitting diodes (LED) is in the form of a red light-emitting diode (R), a green light-emitting diode (G), a blue light-emitting diode (B) and a white light-emitting diode.

8. The measurement arrangement according to any of the preceding claims, **characterised in that** the photodiode (FD) is configured to be wide-band.

9. The measurement arrangement according to any of the preceding claims, **characterised in that** the change in brightness intensity is detected as a function of a user input.

10. A method for detecting ageing processes in individual light-emitting diodes (LED), having the steps of:
- providing (100) a plurality of light-emitting diodes (LED), comprising a red light-emitting diode (R), a green light-emitting diode (G) and a blue light-emitting diode (B);
- providing (101) a control unit (CTRL) arranged to individually regulate the brightness intensity of each of the light-emitting diodes (LED), **characterised in that**
- at least two photodiodes (FD) respectively arranged to measure the brightness intensity of one light-emitting diode (LED) of the plurality of light-emitting diodes (LED) which does not correspond to the red light-emitting diode (R) are provided (102), causing the red light-emitting diode (R) not to be monitorable, the control unit (CTRL) detecting (105) a relative change in brightness intensity in each light-emitting diode (LED) of the plurality of light-emitting diodes (LED) as a function of a first measurement (103) and a second measurement (104) being time-offset to the first measurement, wherein respectively for the green light-emitting diode (G) and the blue light-emitting diode (B) a separate photodiode (FD) is provided.

11. The method according to claim 10, **characterised in that** the detected change in brightness intensity is substantially compensated (106).

12. A computer program product comprising control commands which implement the method according to either claim 10 or claim 11.

## Revendications

1. Agencement de mesure pour détecter des processus de vieillissement de diodes électroluminescentes (LED) individuelles, présentant :
- une pluralité de diodes électroluminescentes (LED) comprenant une diode électroluminescente rouge (R), une diode électroluminescente verte (G) et une diode électroluminescente bleue (B) ;
- une unité de commande (CTRL) conçue pour réguler individuellement l'intensité de luminosité de chacune des diodes électroluminescentes (LED),
**caractérisé en ce**
- **qu'**au moins deux photodiodes (FD), conçues chacune pour mesurer l'intensité de luminosité d'une diode électroluminescente (LED) de la pluralité de diodes électroluminescentes (LED) qui ne correspond pas à la diode électroluminescente rouge (R), sont prévues, de sorte que la diode électroluminescente rouge (R) ne peut pas être surveillée, l'unité de commande (CTRL) étant conçue pour détecter une variation relative d'intensité de luminosité d'une diode électroluminescente de la pluralité de diodes électroluminescentes (LED) en fonction d'une première mesure et d'une deuxième mesure décalée dans le temps par rapport à la première mesure, une photodiode séparée étant prévue respectivement pour la diode électroluminescente verte (G) et pour la diode électroluminescente bleue (B).

2. Agencement de mesure selon la revendication 1, **caractérisé en ce que** l'unité de commande (CTRL) est conçue pour sensiblement compenser la variation d'intensité de luminosité détectée.

3. Agencement de mesure selon la revendication 1 ou 2, **caractérisé en ce que** ladite au moins une diode électroluminescente (LED) est commandée de sorte que l'intensité de luminosité de la première mesure soit obtenue.

4. Agencement de mesure selon l'une des revendications précédentes, **caractérisé en ce que** la pluralité de diodes électroluminescentes (LED) et lesdites au moins deux photodiodes (FD) sont disposées dans un boîtier.

5. Agencement de mesure selon l'une des revendications précédentes, **caractérisé en ce que** la pluralité de diodes électroluminescentes (LED) et lesdites au moins deux photodiodes (FD) sont formées d'une seule pièce.

6. Agencement de mesure selon l'une des revendications précédentes, **caractérisé en ce que** l'unité de commande (CTRL) est présente sous la forme d'un microcontrôleur, d'une machine à états finis, d'une boucle de régulation analogique et/ou d'un composant électronique.

7. Agencement de mesure selon l'une des revendications précédentes, **caractérisé en ce que** la pluralité de diodes électroluminescentes (LED) sont présentes sous la forme d'une diode électroluminescente rouge (R), d'une diode électroluminescente verte (G), d'une diode électroluminescente bleue (B) et d'une diode électroluminescente blanche.

8. Agencement de mesure selon l'une des revendications précédentes, **caractérisé en ce que** la photodiode (FD) est conçue à large bande.

9. Agencement de mesure selon l'une des revendications précédentes, **caractérisé en ce que** la variation d'intensité de luminosité est détectée en fonction d'une entrée d'utilisateur.

10. Procédé pour détecter des processus de vieillissement de diodes électroluminescentes (LED) individuelles, présentant les étapes consistant à :
- mettre à disposition (100) une pluralité de diodes électroluminescentes (LED) comprenant une diode électroluminescente rouge (R), une diode électroluminescente verte (G) et une diode électroluminescente bleue (B) ;
- mettre à disposition (101) une unité de commande (CTRL) conçue pour réguler individuellement l'intensité de luminosité de chacune des diodes électroluminescentes (LED),
**caractérisé en ce**
- **qu'**au moins deux photodiodes (FD), conçues chacune pour mesurer l'intensité de luminosité d'une diode électroluminescente de la pluralité de diodes électroluminescentes (LED) qui ne correspond pas à la diode électroluminescente rouge (R), sont prévues (102), de sorte que la diode électroluminescente rouge (R) ne peut pas être surveillée, l'unité de commande (CTRL) détectant (105) une variation relative d'intensité de luminosité d'une diode électroluminescente de la pluralité de diodes électroluminescentes (LED) en fonction d'une première mesure (103) et d'une deuxième mesure (104) décalée dans le temps par rapport à la première mesure, une photodiode séparée étant prévue respectivement pour la diode électroluminescente verte (G) et pour la diode électroluminescente bleue (B).

11. Procédé selon la revendication 10, **caractérisé en ce que** la variation d'intensité de luminosité détectée est sensiblement compensée (106).

12. Produit programme d'ordinateur comportant des instructions de commande qui mettent en oeuvre le procédé selon l'une des revendications 10 ou 11.
